# EUROPEAN PATENT SPECIFICATION

(11) **EP 4 420 499 B1**
(45) Date of publication and mention of the grant of the patent: **15.10.2025**
(21) Application number: 22798195.8
(22) Date of filing: 21.10.2022
(51) Int. Cl.: H10N 59/00

(54) **INTEGRATED MAGNONIC DEVICE**
INTEGRIERTE MAGNONISCHE VORRICHTUNG
DISPOSITIF MAGNONIQUE INTÉGRÉ

(30) Priority: 21.10.2021 EP 21204050
(43) Date of publication of application: 28.08.2024
(73) Proprietor: Politecnico di Milano, 20133 Milano (IT)
(72) Inventor: BERTACCO, Riccardo, 20133 Milano (IT); MASPERO, Federico, 20133 Milano (IT); PIRRO, Philipp, 66482 Zweibrücken (DE)
(74) Representative: Di Bernardo, Antonio
(86) International application number: PCT/IB2022/060130
(87) International publication number: WO 2023/067563

(56) References cited:
- WO-A1-2012/121673
- US-B1- 9 551 686
- HAAS O ET AL: "Sensitivity and Noise of a Magnetic Field Sensor Based on Magnetostatic Spin Wave YIG Device and Its Integrated Electronics", IEEE SENSORS JOURNAL, vol. 20, no. 23, 10 July 2020 (2020-07-10), pages 14148 - 14156, XP011819281, DOI: 10.1109/JSEN.2020.3008555

## Description

### TECHNICAL FIELD

The invention relates to the field of magnonics devices.

### BACKGROUND ART

Spintronics and magnonics are recent fields of magnetism which aim to develop devices able to transfer, process, store information through electrons spin. The advantages of this approach are several. Adding the spin-degree of freedom to conventional (charge based) electronics offers intriguing opportunities for memory, computing and sensing applications. Relevant success stories in Spintronics are AMR (anisotropic magnetoresistance), GMR (giant magnetoresistance) and TMR (tunneling magnetoresistance) magnetic field sensors for the reading heads of hard disks, non-volatile magnetic memories (MRAM) based on magnetic tunneling junction using Spin Transfer Torque (STT) or Spin Orbit Torque (SOT) for writing. Other promising applications are in the field of magnetic biosensing, where GMR or TMR sensors are used to detect the stray field of magnetic nanoparticles used as label of a biomolecular recognition event at the surface of a microarray. More recently spintronics moved towards the field of computing, both in the framework of Boolean (digital) computing and in that of emerging analog computing strategies (wave computing, neuromorphic computing and quantum computing). Ideal candidates for wave computing are spin waves, or magnons, corresponding to collective excitation of the spin lattice with wave behavior, associated to the local precession of spins around an axis, corresponding to the effective field usually defined by an external DC magnetic field, with progressive phase shift along the direction of propagation. Noteworthy, spin-waves (SWs) provide Joule-heat-free transfer of information and offer promising prospects for miniaturization of devices operating in the GHz-THz range, while the exploitation of SWs phase and "polarization" offers an additional degree of freedom enabling advanced analog computing.

For magnonic devices, i.e. devices exploiting SWs, there is a need to apply an external magnetic field which controls the propagation mode and the dispersion relation of the spin waves. Thus, the external field provides a mean to tune or reconfigure the characteristics of a magnonic device.

Usually said external magnetic field is produced by bulky electromagnets (Helmholtz coil, electromagnet...) or permanent magnets, which cannot be easily integrated in microsystems and microchips. This approach allows large flexibility although it is not compatible with device scalability and integration.

In some cases, the magnetic field necessary for operation of magnonic devices is generated by means of coils or current lines which are integrated in the microchip, but the magnitude of fields that can be produced are limited by the joule dissipation.

There is therefore a need for a magnonic device of small dimensions and low energy consumption.

WO2012121673 discloses systems and methods for SW-based metrology.

US9551686B1 discloses a method and apparatus for non-invasive, real time analysis of physical and chemical properties of a medium employing electromagnetic waves induced by an excitation transducer within longitudinally magnetized strips of ferromagnetic film serving as a waveguide.

In the scientific article "Sensitivity and Noise of a Magnetic Field Sensor Based on Magnetostatic Spin Wave YIG Device and Its Integrated Electronics", IEEE SENSORS JOURNAL, vol. 20, no. 23, 10 July 2020, pages 14148-14156, HAAS O et al. investigate the ability of spin wave propagation phenomenon to be used as a magnetometer.

### OBJECTS AND SUMMARY OF THE INVENTION

An object of the present invention is to overcome at least some of the drawbacks of the prior art. In particular, an object of the present invention is to overcome some of the above-mentioned problems of the known magnonic devices.

An object of the invention is to reduce dimensions of known magnonic devices and to present a solution which can be scalable to micrometric dimensions.

Another object of the invention is to provide a magnonic device requiring low energy consumption.

A further object is to provide a magnonic device wherein the local magnetic field experienced by said device can be easily tuned or reconfigured.

These objects are achieved by means of a device according to the annexed claims.

In one aspect, the invention relates to a magnonic device comprising at least a permanent micromagnet, a magnetic medium suitable for the propagation of spin waves, and a source of spin waves suitable for generating a spin wave in the magnetic medium and a spin wave detector. The magnonic device further comprises a microactuator suitable for changing the relative position between the permanent micromagnet and the magnetic medium.

The hybrid structure of the invention allows to apply the bias magnetic field of magnonic devices without requiring a huge external source (Helmholtz coil, electromagnet...). The permanent micromagnet - or the plurality of micromagnets depending on the embodiments - and the magnetic medium are integrated in a microsystem. The microactuator permits to change the positioning of the permanent micromagnet - or micromagnets - with respect to the magnetic medium, thus altering the stray field experienced by said magnetic medium. In such a way, a tunable SWs manipulation can be achieved exploiting the local magnetic field produced by the permanent micromagnet/s, allowing reconfigurable and low power consumption functionalities.

Preferably, the microactuator is a MEMS device. The use of MEMS technology is advantageous in that it provides reliable solutions.

In some embodiments, the MEMS device comprises a movable part and a fixed part. In some embodiments the movable part supports the permanent micromagnet (or micromagnets if more than one is used) and is movable with respect to the fixed part. The magnonic medium can be either supported by the fixed part of the MEMS or can be fabricated on another chip positioned in close proximity (preferably between 1 µm and 50 µm) to the MEMS carrying the permanent micromagnet in such a way that the magnetic field lines of the permanent micromagnet/s cross the magnetic medium.

In other embodiments the movable part supports the magnetic medium and is movable with respect to the fixed part. The permanent micromagnet/ s can be either supported by the fixed part of the MEMS or can be supported by another chip positioned in close proximity (preferably between 1 µm and 50 µm) to the magnetic medium in such a way that the magnetic field lines of the permanent micromagnet/s cross the magnetic medium.

In some embodiments, the source of spin waves (SWs) is a transmitting antenna adapted to emit a radio frequency signal causing excitation of a spin wave in the magnetic medium.

In some embodiments, the detector of spin waves is a receiving antenna, alternatively it can be an optical detector, a magnetic tunneling junction or any other device suitable to transduce spin waves into an optical or electronic signal.

In some embodiments, the source of spin waves comprises a nano-oscillator suitable for exciting a spin wave in the magnetic medium. The nano-oscillator is preferably integrated on a same chip with the magnetic medium.

In some embodiments, the detector of spin waves comprises a spintronic device, which is preferably integrated on a same chip with the magnetic medium.

According to some embodiments, the magnetic medium and the permanent micromagnet/ s are provided on one monolithic chip.

According to other embodiments, the magnonic device comprises a first chip comprising the permanent micromagnet and the microactuator, and a second chip comprising the magnetic medium. Preferably, the first chip is flip-chip bonded to the second chip.

The magnonic device of the invention can be manufactured by means of different know and reliable technologies, in order to satisfy specific needs.

Further features and advantages of the present invention will be more evident from the description and from the accompanying drawings.

### BRIEF DESCRIPTION OF THE DRAWINGS

The invention will be described below with reference to some not limitative examples, provided by way of example and not as a limitation in the annexed drawings. These drawings show different aspects and embodiments of the present invention and, where appropriate, reference numerals showing like structures, components, materials and/or elements in different figures are denoted by like reference numerals.
Figure 1 illustrates a magnonic device according to a first embodiment of the present invention;
Figure 2a illustrates a schematic fabrication process of the microactuator of figure 4a for use in the magnonic device of figure 4c;
Figure 2b illustrates a flow chart of the fabrication process of figure 2a;
Figure 3a illustrates a schematic fabrication flow of a monolithic magnonic device;
Figure 3b illustrates a flow chart of the fabrication process of figure 3a;
Figure 4a illustrates a microactuator in the form of a MEMS chip;
Figure 4b illustrates a spin wave chip for generating, guiding and detecting a spin wave;
Figure 4c illustrates a device according to an embodiment of the invention obtained by flip-chip integration of the MEMS chip of figure 4a on the spin wave chip of figure 4b;
Figure 5 shows a possible embodiment of the invention, wherein a permanent micromagnet perturbates a continuous film, and wherein some parts are not represented for greater clarity; and
Figure 6 represents a permanent micromagnet for use in the magnonic device according to the invention;
Figure 7 represents a simulation of the stray field produced by the permanent micromagnet of figure 6;
Figure 8 represents components of the magnetic field generated by the permanent micromagnet of figure 6 at three micrometers distance from the permanent micromagnet.

### DETAILED DESCRIPTION

While the invention is susceptible to various modifications and alternative constructions, some preferred embodiments are shown in the drawings and will be described in detail herein below. It should be understood, however, that there is no intention to limit the invention to the specific disclosed embodiment but, on the contrary, the invention intends to cover all modifications and alternative constructions that fall within the scope of the invention as defined in the claims.

The use of "for example", "etc.", "or" indicates non-exclusive alternatives without limitation, unless otherwise defined.

The use of "includes" means "includes, but not limited to", unless otherwise defined.

The invention relates to a magnonic device 1 comprising a permanent micromagnet 3, a magnetic medium 4 suitable for the propagation of spin waves 7, and a microactuator 2 for changing the relative position between the permanent micromagnet 3 and the magnetic medium 4.

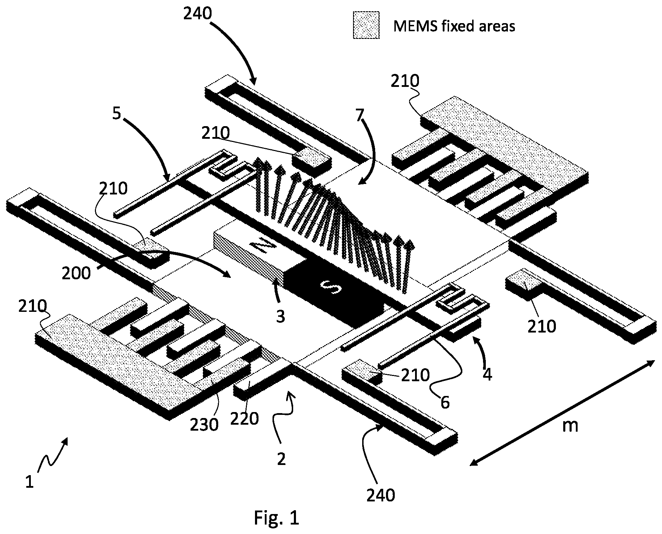

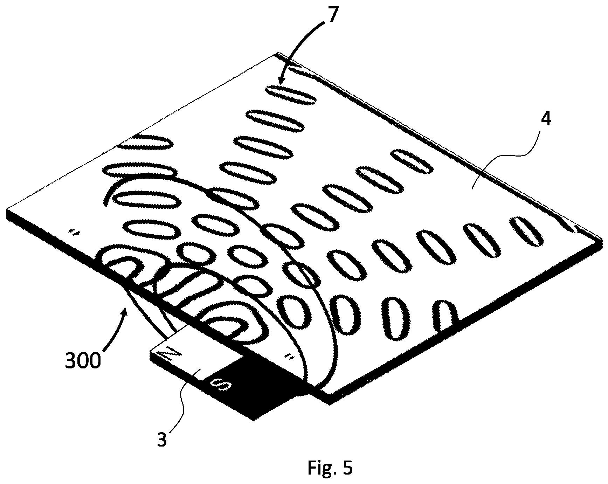

The magnetic medium 4, suitable for the propagation of spin waves 7, is preferably made of a ferromagnetic, ferrimagnetic or antiferromagnetic material. According to some embodiments of the invention, the magnetic medium 4 is a waveguide having a substantially linear development (e.g., see figure 1). According to other embodiments, the magnetic medium 4 is a portion of a continuous magnetic film or magnetic plate having a substantially planar development, as illustrated in the example of figure 5 where the magnetic field lines 300 of the permanent micromagnet 3 crosses the magnetic medium 4 wherein spin waves 7 propagates). According to other embodiments, the magnetic medium 4 is a non-planar element, i.e. with a surface that is not flat, namely that it does not rest in a plane.

Preferably, the microactuator 2 is a MEMS device. According to some embodiments of the invention, the microactuator 2 is configured for moving the permanent micromagnet 3 between at least two positions relative to the magnetic medium 4, the latter being fixed on the magnonic device 1. Alternatively, according to other embodiments of the invention, the microactuator 2 is configured for moving the magnetic medium 4 between at least two positions relative to the permanent micromagnet 3, the latter being fixed on the magnonic device 1.

In the following the case is described in detail where a permanent micromagnet 3 is mounted on top of the movable part of the microactuator 2 and the magnetic medium 4 is fixed. As the skilled person can easily understand, the dual case comprising a fixed permanent micromagnet 3 and a movable magnetic medium 4 is an obvious extension of the case treated below.

The relative movement between the permanent micromagnet 3 and the magnetic medium 4, imposed by the microactuator 2, allows to change the stray field experienced by the magnetic medium 4 and to tune the functionalities of the magnonic device 1.

Fig.1 illustrates a magnonic device 1 according to an embodiment of the present invention.

A microactuator 2, as an example implemented through a Micro-ElectroMechanical System (MEMS) is functionalized with a permanent micromagnet 3. The microactuator 2, in a manner known per se, can move either in-plane or out-of-plane by means of electric actuation (electrostatic, piezoelectric) or other type of actuation (magnetostatic, thermal, etc..) not illustrated in figure 1 for sake of clarity.

In the embodiment of figure 1, the microactuator 2 comprises a movable part 200 that can be moved with respect to a fixed part 210 along an m direction represented in figure 1 by an arrow. Both the movable part 200 and the fixed part 210 are provided with comb like profiles with interdigitated fingers 220 and 230. As known in the art, by applying a difference of potential between fingers 220 and 230, the movable part 200 moves with respect to the fixed part 210. Springs 240 are provided to return the movable part 200 in a rest position when the difference of potential between fingers 220 and 230 is not applied and to sustain the moving part of the MEMS.

The permanent micromagnet 3 can be integrated on the microactuator 2 during manufacturing of the magnonic device 1 or assembled on the microactuator 2 at the end of the manufacturing process. Permanent micromagnet has preferably dimensions lower than 900 µm and more preferably lower than 500 µm.

The permanent micromagnet 3 is preferably a patterned film of ferromagnetic or ferrimagnetic material with large coercivity (e.g. > 10⁴ A/m) and large remanent magnetization (e.g. > 10⁵ A/m), able to generate a strong magnetic field in its proximity (e.g. > 10⁵ A/m).

The functionalized microactuator 2 is coupled at chip level or at wafer level (either via flip-chip/wafer bonding or monolithically) to a magnetic medium 4 suitable for the excitation, propagation, interaction and detection of spin waves 7. The magnetic medium 4 comprises of a properly shaped magnetic element (e.g. a magnonic waveguide, a continuous film or a non-planar structure), preferably made of a ferromagnetic, ferrimagnetic or antiferromagnetic materials. Examples of ferromagnetic materials are NiFe (Nickel Iron) and CoFeB (Cobalt Iron Boron); an example of ferrimagnetic material is YIG (Yttrium Iron Garnet); and an example of antiferromagnetic material is NiO (Nickel Oxide).

Advantageously, a transducer or source of spin waves 5 is coupled to (e.g. manufactured on top of) the magnetic medium 4. The source of spin waves 5 can comprise, for example, a transmitting radio frequency (RF) antenna, a Spin Torque Nano Oscillator, or any other devices suitable for exciting spin waves in the magnetic medium 4. The source of spin waves 5 can be fed with an electric signal, either AC or DC depending on the kind of source used, e.g. an antenna can be fed with an RF electric signal, while a Spin Torque Nano Oscillator can be fed with a DC current. The electric signal can be generated by a control unit (not shown) able to generate the electric signal, e.g. according to a software algorithm. Alternatively, the electric signal can be generated by RF antenna suitable for receiving radio signals, in particular microwave signals, from open space (e.g. WLAN or data transmission network). The electric current generated in the antenna is then fed (either amplified or not) to the RF antenna being placed in proximity of the magnetic medium, thereby causing excitement of spin waves in the magnetic medium. In one embodiment, the electric signal can be generated by a passive device, like an antenna receiving radio signals and connected to another antenna placed in proximity of the magnetic medium.

At least one detector of spin waves 6 is coupled to (e.g. manufactured on top of) an opposite end of the magnetic medium 4 in order to detect the spin wave 7 propagating in said magnetic medium 4. The detector of spin waves 6 can be for example an RF receiving antenna, a magnetic tunneling junction, a device exploiting magnetoelectric coupling, a spintronic device etc. According to some embodiments, the device of the invention comprises a plurality of detectors of spin waves 6.

The bias magnetic field to control the spin wave 7 propagation is provided by the permanent micromagnet 3 on the microactuator 2.

The magnitude and direction of the bias field can be modulated by operating the microactuator 2 thereby changing the relative position between the permanent micromagnet 3 and the magnetic medium 4. The change of bias field can be used to manipulate the spin waves propagation enabling reconfigurability of the magnonic device 1. As an example, by moving the relative position of the permanent micromagnet with respect to the waveguide 4 of figure 1, it is possible to filter different frequency components of the electromagnetic signal emitted by the antenna 5, thereby receiving only determined frequency components at the detector 6.

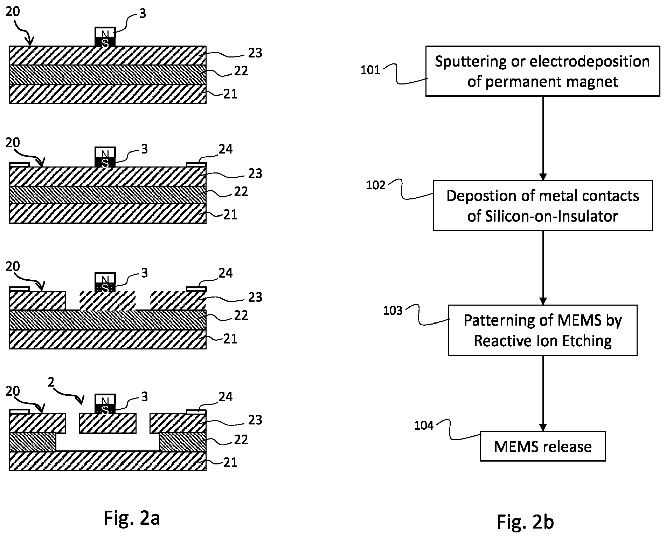

Figure 2 schematically shows an example of fabrication of a microactuator 2 carrying a permanent micromagnet 3. In a first step (step 101) permanent micromagnets 3 are fabricated by sputtering or electrodeposition and lithography on a three-layer wafer 20 comprising a lower silicon substrate 21, an intermediate insulating layer 22 of SiO₂, an upper silicon layer 23. Then, in a second step (step 102), metal contacts 24 are deposited on the upper silicon layer 23. After that (step 103), the upper silicon layer 23 is selectively etched using Reactive Ion Etching to define the MEMS structure. Finally (step 104), the intermediate silicon dioxide layer 22 is etched by hydrofluoric acid thereby releasing the MEMS.

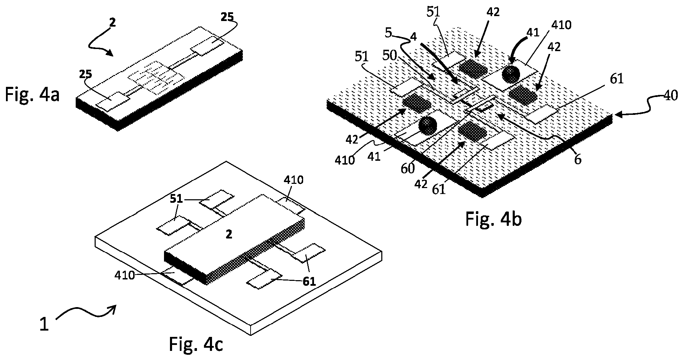

The microactuator 2 obtained via the process of figure 2 can be used in a flip-chip integration process shown in Figures 4a, 4b and 4c, where the microactuator 2 (MEMS chip of figure 4a) obtained by the process of figure 2 is flipped and positioned on a spinwave chip 40 illustrated in figure 4b, thereby obtaining the magnonic device of figure 4c. A similar coupling can be obtained at wafer levels by wafer to wafer bonding.

Figure 4a schematically illustrates the microactuator 2 with the comb like structure and the permanent magnet (not illustrated in this figure) supported by the movable part of the MEMS. Figure 4a also shows electric contacts 25 of the microactuator through which displacement of the movable part can be controlled.

The spin wave chip 40 comprises a magnetic medium 4 (in this example a rectangular waveguide), the source of spin waves (a transmitting antenna 5) and the detector of spin waves (a receiving antenna 6). In the example of figure 4b, antennas 5 and 6 are represented by copper lines (50, 60) manufactured above the waveguide 4 and with electric contacts (51, 61) at their ends.

In a per se known way, the spin wave chip 40 is provided with balls for flip chip bonding 41 positioned on respective metal areas 410. Spacers 42 are also provided for supporting the flipped microactuator chip 2.

The MEMS chip 2 is flipped (so that the permanent magnet faces the waveguide) and bonded to the spin wave chip 40 with electric contacts 25 being positioned above the metal areas 410. Other technologies for bonding with polymers, eutectic alloys, etc. can be suitable.

Preferably, the MEMS chip is maintained in close proximity, preferably between 1 µm and 50 µm, from the spin wave chip 40.

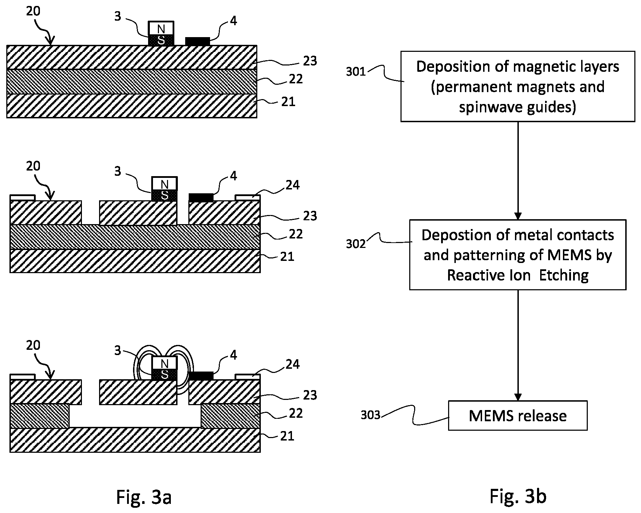

Figure 3 shows an alternative example of fabrication of a magnonic device 1 according to the invention. In this example, the magnonic device 1 is manufactured on a monolithic chip, with the permanent micromagnet 3 on the movable part of the MEMS and the magnetic medium 4 on the fixed part, so that the relative motion of the two causes a change in the stray field experienced by the spin wave 7 propagating in the magnetic medium 4.

In the example of figure 3 the magnetic layers (permanent micromagnet 3 and magnetic medium 4) are deposited on a three-layer wafer 20 (step 301) similar to that of figure 2. Then (step 302) metal contacts 24 are deposited on the silicon upper layer 23 to provide device polarization and, after that, the upper silicon layer 23 is selectively etched using Reactive Ion Etching to define the MEMS structure. Finally (step 303), the intermediate silicon dioxide layer 22 is etched by hydrofluoric acid thereby releasing the MEMS.

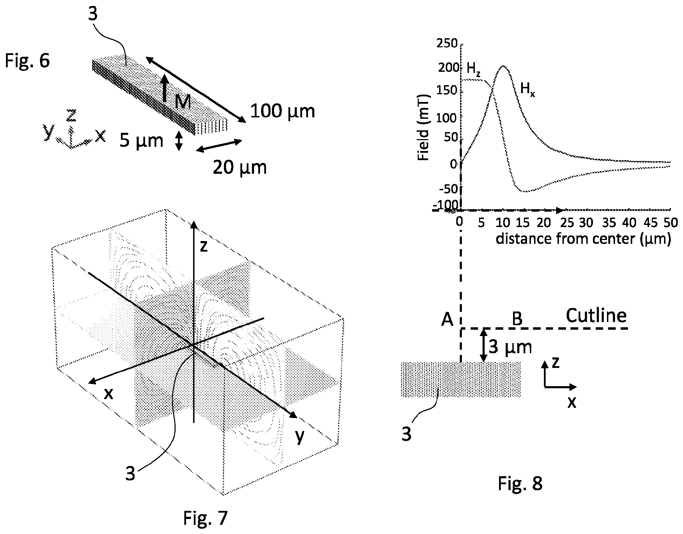

An example of a permanent micromagnet 3 which could be used in the framework of the present invention is reported in Figure 6. According to such embodiment, the permanent micromagnet 3 is shaped as a bar with 100 µm length and a rectangular cross section (20 µm x 5 µm), magnetized in the out of plane direction (z direction in figure 6) with a remanent magnetization M = 1.1 MA/m.

The lines of the magnetic stray field H produced by said permanent micromagnet 3 in the high symmetry planes of the magnet are shown in figure 7. It is evident that especially along the x direction there is a fast change of the direction of the stray field.

In Figure 8 the Hx and Hz components are plotted as a function of the x coordinate along a cutline at 3 µm height above the permanent micromagnet 3, which represents a realistic distance at which a magnetic medium 4 (e.g. a magnonic conduit or waveguide) could be placed in a filp-chip configuration. The field is exactly out-of-plane (parallel to z) for x=0, at the center of the permanent micromagnet 3, while Hx gradually increases till it reaches a maximum at the edge of the permanent micromagnet 3, for x=10 µm, where Hz=0. This means that moving along this cutline from the center to the edge the stray field is first out of plane and then in plane.

If this permanent micromagnet 3 is coupled to a magnonic waveguide with small width, on the order of 200 nm, and 20 nm thickness, it is possible to safely assume that if said waveguide is placed parallel to the permanent micromagnet 3 (with its length along y), at 3 µm height and with its axis at x=0 (position A in Figure 6c) it will feel a field perpendicular to its surface. On the other hand, if the same waveguide is moved to position B (on top of the permanent micromagnet 3 edge) the bias field will be mainly in-plane. This translates into completely different classes of SWs 7 that can be excited and propagate in the waveguide: Forward Volume SWs in position A and Damon Eshbach SWs in position B. Noteworthy they have a completely different dispersion relation so that the functionality of any device exploiting their propagation in the waveguide could be tuned by changing the relative position of the waveguide with respect to the permanent micromagnet 3.

Note that what is relevant is the relative position of the waveguide (magnetic medium 4) and the permanent micromagnet 3. This means that the reconfiguration of the functionality of the magnonic device 1 can be achieved in two ways: (i) by placing the permanent micromagnet 3 on the movable part of the MEMS and the magnetic 4 either on the fixed part of the same MEMS in the monolithic approach or in another chip coupled to the MEMS (e.g. in the flip-chip approach); (ii) by placing the magnetic medium 4 on the movable part of the MEMS and the permanent micromagnet 3 either on the fixed part of the same MEMS in the monolithic approach or in another chip coupled to the MEMS (e.g. in the flip-chip approach).

According to another aspect, the invention relates to a microsystem or microchip comprising a magnonic device 1 according to what is disclosed above.

As it can be easily understood, the present invention overcomes some of the drawbacks of the prior art. In particular, the present invention overcomes some of the problems mentioned above with respect to the known magnonic devices.

Moreover, the present invention provides a magnonic device with reduced dimensions with respect to known magnonic devices and provides a solution which can be scalable to micrometric dimensions.

Furthermore, the present invention provides a magnonic device which requires low energy consumption.

Lastly, the present invention provides a magnonic device in which the local magnetic field can be easily tuned or reconfigured
All the details described above can be replaced by other technically equivalent elements, according to knowledge of the skilled person. In practice, the materials used, as well as the contingent shapes and sizes, can be whatever according to the requirements without for this reason departing from the scope of protection of the following claims.

As an example, the permanent micromagnet 3 described above is a single body element, nevertheless, in alternative embodiments the permanent micromagnet 3 can be replaced by a plurality of micromagnets 3 created or mounted on chip to realize a specific field configuration. According to the invention, therefore, at least one micromagnet is necessary, nevertheless, a plurality of micromagnets can be used.

Moreover, in case the source of spin waves comprises a nano-oscillator, the latter can be integrated on a same chip with the magnetic medium.

In the same way, in case the detector of spin waves comprises a spintronic device, the latter can be integrated on a same chip with the magnetic medium.

## Claims

1. Magnonic device (1) comprising:
- at least one permanent micromagnet (3),
- a magnetic medium (4) suitable for the propagation of spin waves (7),
- a source of spin waves (5) suitable for generating a spin wave in the magnetic medium,
- a detector (6) for detecting spin waves propagating in the magnetic medium (4) and a
- microactuator (2) for changing the relative position between the at least one permanent micromagnet (3) and the magnetic medium (4).

2. A magnonic device (1) according to claim 1, wherein the microactuator (2) is a MEMS device.

3. A magnonic device (1) according to claim 2, wherein the MEMS device comprises a movable part (20) and a fixed part (21), wherein the movable part supports the at least one permanent micromagnet and is movable with respect to the fixed part.

4. A magnonic device (1) according to claim 3, wherein the fixed part supports the magnetic medium (4).

5. A magnonic device (1) according to claim 2, wherein the MEMS device comprises a movable part (20) and a fixed part (21), wherein the movable part supports the magnetic medium (4) and is movable with respect to the fixed part.

6. A magnonic device (1) according to claim 5, wherein the fixed part supports the at least one permanent micromagnet (3).

7. A magnonic device (1) according to any of the previous claims, wherein the source of spin waves (5) comprises an antenna adapted to excite spin waves (7) in the magnetic medium (4) when fed with a RF signal.

8. A magnonic device (1) according to claim 7, wherein the detector of spin waves (6) comprises a receiving antenna.

9. A magnonic device (1) according to any of the previous claims , wherein the magnetic medium is a magnetic waveguide and wherein the source of spin waves (5) and detector of spin waves (6) comprise antennas placed at opposite ends of the waveguide.

10. A magnonic device (1) according to claim 1 or 2 or 3 or 4 or 5 or 6, wherein the source of spin waves comprises a nano-oscillator integrated on a same chip with the magnetic medium.

11. A magnonic device (1) according to claim 1 or 2 or 3 or 4 or 5 or 6, wherein the detector of spin waves comprises a spintronic device integrated on a same chip with the magnetic medium.

12. A magnonic device (1) according to one or more of the preceding claims, wherein the magnetic medium (4) and the at least one permanent micromagnet (3) are provided on one monolithic chip.

13. A magnonic device (1) according to one or more of claims 1 or 2, comprising a first chip comprising the at least one permanent micromagnet (3) and the microactuator (2), and a second chip comprising the magnetic medium (4).

14. A magnonic device (1) according to claim 13, wherein the first chip is flip-chip bonded to the second chip.

15. A magnonic device (1) according to claim 12 or 13, wherein the second chip comprises the source of spin waves (5) and the detector of spin waves (6).

16. A magnonic device (1) according to claim 15, wherein the source of spin waves (5) comprises an antenna adapted to emit a radio frequency signal causing excitation of a spin wave (7) in the magnetic medium (4).

17. A magnonic device (1) according to claim 16, wherein the detector of spin waves (6) comprises a receiving antenna.

## Patentansprüche

1. Magnonische Vorrichtung (1), umfassend:
- mindestens einen Permanentmikromagneten (3),
- ein magnetisches Medium (4), welches zum Ausbreiten von Spinwellen (7) geeignet ist,
- eine Quelle von Spinwellen (5), welche zum Erzeugen einer Spinwelle in dem magnetischen Medium geeignet ist,
- einem Detektor (6) zum Erfassen von sich im magnetischen Medium (4) ausbreitenden Spinwellen, und einen
- Mikro-Aktuator (2) zur Veränderung der relativen Position zwischen dem mindestens einen Permanentmikromagneten (3) und dem magnetischen Medium (4).

2. Magnonische Vorrichtung (1) nach Anspruch 1, wobei der Mikro-Aktuator (2) eine MEMS-Vorrichtung ist.

3. Magnonische Vorrichtung (1) nach Anspruch 2, wobei die MEMS-Vorrichtung einen beweglichen Teil (20) und einen festen Teil (21) umfasst, wobei der bewegliche Teil den mindestens einen Permanentmikromagneten trägt und in Bezug auf den festen Teil beweglich ist.

4. Magnonische Vorrichtung (1) nach Anspruch 3, wobei der feste Teil das magnetische Medium (4) trägt.

5. Magnonische Vorrichtung (1) nach Anspruch 2, wobei die MEMS-Vorrichtung einen beweglichen Teil (20) und einen festen Teil (21) umfasst, wobei der bewegliche Teil das magnetische Medium (4) trägt und in Bezug auf den festen Teil beweglich ist.

6. Magnonische Vorrichtung (1) nach Anspruch 5, wobei der feste Teil den mindestens einen Permanentmikromagneten (3) trägt.

7. Magnonische Vorrichtung (1) nach einem der vorhergehenden Ansprüche, wobei die Quelle von Spinwellen (5) eine Antenne, die, wenn mit einem HF-Signal gespeist, geeignet ist, Spinwellen (7) in dem magnetischen Medium (4) anzuregen, umfasst.

8. Magnonische Vorrichtung (1) nach Anspruch 7, wobei der Detektor für Spinwellen (6) eine Empfangsantenne umfasst.

9. Magnonische Vorrichtung (1) nach einem der vorhergehenden Ansprüche, wobei das magnetische Medium ein magnetischer Wellenleiter ist und wobei die Quelle von Spinwellen (5) und der Detektor von Spinwellen (6) die an gegenüberliegenden Enden des Wellenleiters angeordneten Antennen umfassen.

10. Magnonische Vorrichtung (1) nach Anspruch 1 oder 2 oder 3 oder 4 oder 5 oder 6, wobei die Quelle der Spinwellen einen Nano-Oszillator, welcher auf demselben Chip wie das magnetische Medium integriert ist, umfasst.

11. Magnonische Vorrichtung (1) nach Anspruch 1 oder 2 oder 3 oder 4 oder 5 oder 6, wobei der Detektor für Spinwellen eine spintronische Vorrichtung, welche auf demselben Chip wie das magnetische Medium integriert ist, umfasst.

12. Magnonische Vorrichtung (1) nach einem oder mehreren der vorhergehenden Ansprüche, wobei das magnetische Medium (4) und der mindestens eine Permanentmikromagnet (3) auf einem monolithischen Chip vorgesehen sind.

13. Magnonische Vorrichtung (1) nach einem oder mehreren der Ansprüche 1 oder 2, umfassend einen ersten Chip, welcher den mindestens einen Permanentmikromagneten (3) und den Mikro-Aktuator (2) aufweist, und einen zweiten Chip, welcher das magnetische Medium (4) aufweist.

14. Magnonische Vorrichtung (1) nach Anspruch 13, wobei der erste Chip ein mit dem zweiten Chip verbundener Flip-Chip ist.

15. Magnonische Vorrichtung (1) nach Anspruch 12 oder 13, wobei der zweite Chip die Quelle der Spinwellen (5) und den Detektor der Spinwellen (6) umfasst.

16. Magnonische Vorrichtung (1) nach Anspruch 15, wobei die Quelle von Spinwellen (5) eine zum Aussenden eines Hochfrequenzsignals, das die Anregung einer Spinwelle (7) in dem magnetischen Medium (4) bewirkt, geeignete Antenne umfasst.

17. Magnonische Vorrichtung (1) nach Anspruch 16, wobei der Detektor für Spinwellen (6) eine Empfangsantenne umfasst.

## Revendications

1. - Dispositif magnonique (1) comprenant :
- au moins un micro-aimant permanent (3),
- un milieu magnétique (4) approprié pour la propagation d'ondes de spin (7),
- une source d'ondes de spin (5) appropriée pour générer une onde de spin dans le milieu magnétique,
- un détecteur (6) pour détecter des ondes de spin se propageant dans le milieu magnétique (4), et
- un microactionneur (2) pour changer la position relative entre l'au moins un micro-aimant permanent (3) et le milieu magnétique (4).

2. - Dispositif magnonique (1) selon la revendication 1, dans lequel le microactionneur (2) est un dispositif MEMS.

3. - Dispositif magnonique (1) selon la revendication 2, dans lequel le dispositif MEMS comprend une partie mobile (20) et une partie fixe (21), la partie mobile portant l'au moins un micro-aimant permanent et étant mobile par rapport à la partie fixe.

4. - Dispositif magnonique (1) selon la revendication 3, dans lequel la partie fixe porte le milieu magnétique (4).

5. - Dispositif magnonique (1) selon la revendication 2, dans lequel le dispositif MEMS comprend une partie mobile (20) et une partie fixe (21), la partie mobile portant le milieu magnétique (4) et étant mobile par rapport à la partie fixe.

6. - Dispositif magnonique (1) selon la revendication 5, dans lequel la partie fixe porte l'au moins un micro-aimant permanent (3).

7. - Dispositif magnonique (1) selon l'une quelconque des revendications précédentes, dans lequel la source d'ondes de spin (5) comprend une antenne apte à exciter des ondes de spin (7) dans le milieu magnétique (4) lorsqu'elle est alimentée par un signal RF.

8. - Dispositif magnonique (1) selon la revendication 7, dans lequel le détecteur d'ondes de spin (6) comprend une antenne réceptrice.

9. - Dispositif magnonique (1) selon l'une quelconque des revendications précédentes, dans lequel le milieu magnétique est un guide d'ondes magnétique et dans lequel la source d'ondes de spin (5) et le détecteur d'ondes de spin (6) comprennent des antennes placées à des extrémités opposées du guide d'ondes.

10. - Dispositif magnonique (1) selon la revendication 1 ou 2 ou 3 ou 4 ou 5 ou 6, dans lequel la source d'ondes de spin comprend un nano-oscillateur intégré sur une même puce avec le milieu magnétique.

11. - Dispositif magnonique (1) selon la revendication 1 ou 2 ou 3 ou 4 ou 5 ou 6, dans lequel le détecteur d'ondes de spin comprend un dispositif spintronique intégré sur une même puce avec le milieu magnétique.

12. - Dispositif magnonique (1) selon une ou plusieurs des revendications précédentes, dans lequel le milieu magnétique (4) et l'au moins un micro-aimant permanent (3) sont disposés sur une puce monolithique.

13. - Dispositif magnonique (1) selon une ou plusieurs des revendications 1 et 2, comprenant une première puce comprenant l'au moins un micro-aimant permanent (3) et le microactionneur (2), et une seconde puce comprenant le milieu magnétique (4).

14. - Dispositif magnonique (1) selon la revendication 13, dans lequel la première puce est connectée par bossage à la seconde puce.

15. - Dispositif magnonique (1) selon la revendication 12 ou 13, dans lequel la seconde puce comprend la source d'ondes de spin (5) et le détecteur d'ondes de spin (6).

16. - Dispositif magnonique (1) selon la revendication 15, dans lequel la source d'ondes de spin (5) comprend une antenne apte à émettre un signal radiofréquence provoquant l'excitation d'une onde de spin (7) dans le milieu magnétique (4).

17. - Dispositif magnonique (1) selon la revendication 16, dans lequel le détecteur d'ondes de spin (6) comprend une antenne réceptrice.
